# FASCICULE DE BREVET EUROPEEN

(11) **EP 3 610 708 B1**
(45) Date de publication et mention de la délivrance du brevet: **02.06.2021**
(21) Numéro de dépôt: 18714811.9
(22) Date de dépôt: 10.04.2018
(51) Int. Cl.: H05K 5/02

(54) **MODULE ÉLECTRONIQUE À PROTECTION AMELIORÉE CONTRE L'HUMIDITÉ**
ELEKTRONISCHES MODUL MIT VERBESSERTEM SCHUTZ GEGEN FEUCHTIGKEIT
ELECTRONIC MODULE WITH IMPROVED PROTECTION AGAINST HUMIDITY

(30) Priorité: 12.04.2017 FR 1753230
(43) Date de publication de la demande: 19.02.2020
(73) Titulaire: Safran Electronics & Defense, 75015 Paris (FR); Safran Electrical & Power, 31702 Blagnac Cedex (FR)
(72) Inventeur: GUILLOT, François, 75015 Paris (FR); BLINEAU, Jean-Marc, 31702 Blagnac cedex (FR); AVIGNON, Philippe, 31702 Blagnac cedex (FR); ROQUES, Serge, 31702 Blagnac cedex (FR); ALBERO, Franck, 31702 Blagnac cedex (FR)
(74) Mandataire: Prouvez, Julien
(86) Numéro de dépôt international: PCT/EP2018/059146
(87) Numéro de publication internationale: WO 2018/189169

(56) Documents cités:
- WO-A1-03/069749
- DE-A1- 19 813 924
- DE-U1-202014 000 544
- FR-A1- 3 040 582
- US-A1- 2011 072 834

## Description

### DOMAINE DE L'INVENTION

La présente invention concerne le domaine de l'électronique et plus particulièrement les modules comprenant une carte électronique.

### ARRIERE PLAN DE L'INVENTION

On connait des modules électroniques comprenant une carte électronique de traitement de données, des moyens de connexion d'une ligne de données pour permettre un échange de données et d'instructions avec la carte électronique, et des moyens de connexion d'une ligne de puissance pour alimenter la carte électronique en énergie.

Il existe de tels modules électroniques qui sont agencés pour être enfichés parallèlement les uns aux autres dans une baie avionique pourvue de connecteurs destinés à coopérer avec les moyens de connexion de données et de puissance des modules électroniques. La baie avionique dispose d'une ventilation forcée pour assurer le refroidissement des modules électroniques contenus dans la baie avionique.

Les composants électroniques et plus généralement les conducteurs électriques présents sur les cartes électroniques doivent être protégés de la poussière, de l'humidité et des agressions chimiques ou mécaniques de toutes sortes. L'humidité sous forme liquide est en particulier responsable de dysfonctionnements de la carte électronique résultant de la création de courts-circuits ou de l'oxydation des composants électroniques ou des conducteurs de la carte électronique.

Il demeure que les variations thermiques que l'on peut rencontrer dans un aéronef et l'humidité de l'air présent dans celui-ci engendrent des phénomènes de condensation provoquant le dépôt d'humidité sous forme liquide sur la carte électronique.

Il a été envisagé de mettre en œuvre des systèmes d'assèchement d'air dans les baies avioniques. Ces systèmes sont complexes, couteux, encombrants et augmentent la masse du module.

Alternativement, il a été envisagé d'appliquer un vernis protecteur sur l'ensemble de la carte électronique. Le parylène est un élément fréquemment utilisé à cette fin. Cependant, une telle protection par vernis augmente considérablement le poids de la carte, jusqu'à 200% de poids en plus, ce qui est préjudiciable pour une application aéronautique. En outre, la présence de vernis rend quasiment impossible la réparation de la carte électronique, ce qui augmente les couts de maintenance du matériel

L'état de l'art comprend les documents DE-A1-19813924 et US-A1-2011072834.

### OBJET DE L'INVENTION

Un but de l'invention est d'améliorer la protection des modules électroniques contre l'humidité.

### RESUME DE L'INVENTION

A cet effet, on prévoit selon l'invention, un module électronique comprenant une enveloppe de protection délimitant un volume interne et une carte électronique disposée dans le volume interne. Le module électronique comprend des moyens de détection d'une condition environnementale prédéterminée du volume interne et des moyens de génération d'une zone froide à l'intérieur du volume interne agencés pour que la zone froide soit séparée de la carte électronique. Une unité de commande est reliée aux moyens de détection d'une condition environnementale et aux moyens de génération d'une zone froide. Selon l'invention, l'unité de commande est agencée pour déclencher les moyens de génération d'une zone froide lorsque les moyens de détection d'une condition environnementale prédéterminée du volume interne détectent une condition environnementale susceptible de provoquer une condensation de l'humidité de l'air contenu dans le volume interne sur la carte électronique.

Ainsi, l'unité de commande peut, lorsqu'elle détecte des conditions environnementales susceptibles de provoquer une condensation de l'humidité de l'air contenu dans le volume interne, commander les moyens de génération d'une zone froide. On force ainsi la condensation de l'humidité sur la zone froide plutôt que sur la carte électronique. La zone froide étant séparée de la carte électronique, on s'assure que la condensation ne s'effectue pas sur la carte électronique. L'enveloppe de protection protège la carte électronique de la poussière, de l'humidité extérieure, de la fumée et des agressions chimiques ou mécaniques de toutes sortes, rendant inutile une protection de la carte électronique par vernis.

Au sens de la présente demande, une zone froide est un volume ou une surface localisé(e) dont la température est inférieure à celle d'une zone de référence. Une zone froide peut être obtenue par élévation de la température de la zone de référence, ce qui crée un gradient de température et donc l'apparition d'une zone de plus forte température et d'une zone de plus faible température. Une zone froide peut également être obtenue par diminution de la température de ladite zone froide.

De préférence, l'enveloppe de protection est démontable. La carte électronique peut alors être simplement réparée en l'extrayant de l'enveloppe de protection.

Une réalisation particulièrement économique est obtenue lorsque les moyens de détection d'une condition environnementale prédéterminée comprennent un premier capteur de température solidaire de la carte électronique et /ou un deuxième capteur de température solidaire de l'enveloppe de protection. Une détection rapide et simple de l'apparition d'une condition environnementale susceptible de provoquer une condensation de l'humidité de l'air contenue dans le volume interne sur la carte électronique est obtenue lorsque l'unité de commande est agencée pour déclencher les moyens de génération d'une zone froide lorsqu'une température mesurée par le premier capteur de température est inférieure à la température mesurée par le deuxième capteur de température.

On évite de solliciter inutilement les moyens de génération d'une zone froide lorsque l'unité de commande est agencée pour ne déclencher les moyens de génération d'une zone froide que si la température mesurée par le premier capteur de température est inférieure à une température seuil prédéterminée. Ceci permet également de ne pas impacter le temps moyen entre pannes de la carte électronique.

Le module de l'invention est particulièrement robuste lorsque les moyens de génération d'une zone froide comprennent une cellule à effet Peltier qui possède une face chaude et une face froide. Préférentiellement, la face chaude de la cellule Peltier est thermiquement reliée à l'enveloppe de protection ou à un châssis thermiquement conducteur du module électronique.

Avantageusement, les moyens de génération d'une zone froide sont agencés pour que des condensats issus de la condensation de l'air contenu dans le volume interne soient dirigés vers une zone de rétention dédiée du volume interne et/ou vers l'extérieur du volume interne. Avantageusement, la zone de rétention est revêtue d'une résine protectrice.

D'autres caractéristiques et avantages de l'invention ressortiront de la description qui suit d'un mode de réalisation particulier non limitatif de l'invention.

### BREVE DESCRIPTION DES DESSINS

Il sera fait référence aux figures annexées parmi lesquelles :
- la figure 1 est une vue schématique en perspective partiellement écorchée d'un module électronique selon un premier mode de réalisation de l'invention ;
- la figure 2 est une vue schématique en coupe selon le plan II-II du module de la figure 1 ;
- la figure 3 est une vue schématique en perspective partiellement écorchée d'un module électronique selon un troisième mode de réalisation de l'invention.

### DESCRIPTION DETAILLEE DE L'INVENTION

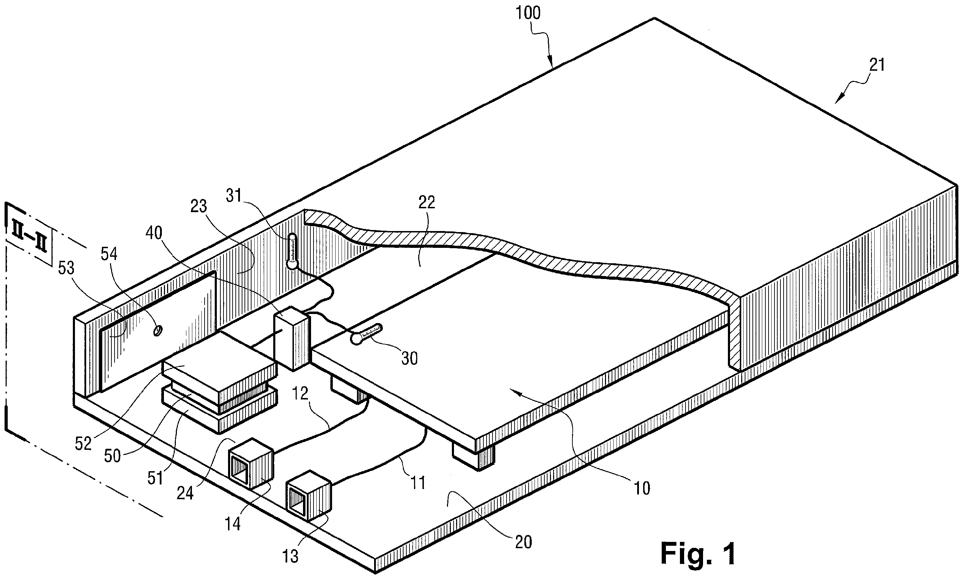

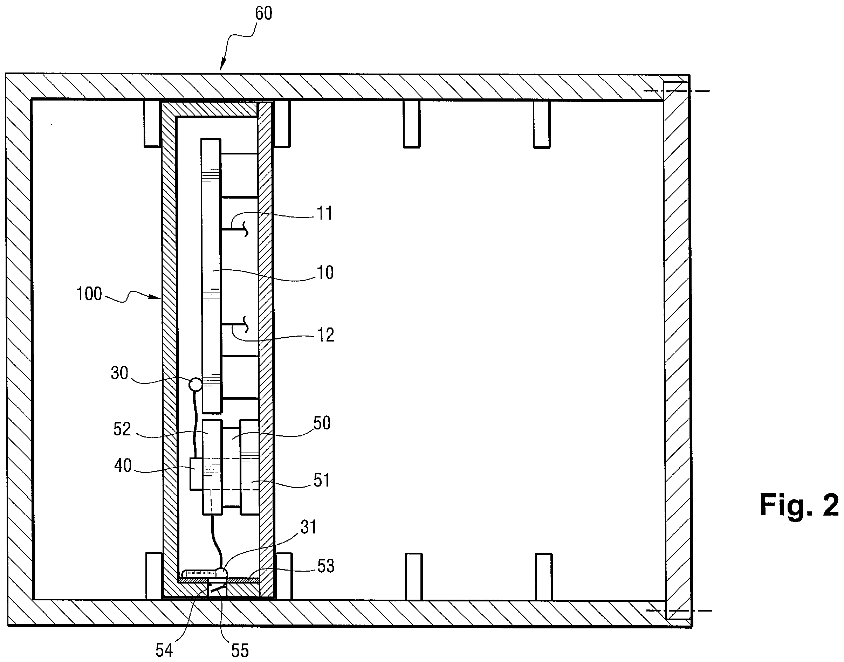

En référence aux figures 1 et 2, le module électronique selon l'invention, et généralement désigné 100, est ici agencé pour être monté dans une baie avionique 60 d'un aéronef (non représenté).

Le module électronique 100 comprend une carte électronique 10 fixée sur une base 20 d'une enveloppe de protection 21. Des pistes électroniques 11 et 12 relient respectivement la carte électronique 10 à un premier connecteur 13 de données et à un deuxième connecteur 14 d'alimentation qui débouchent tous deux sur une surface externe de l'enveloppe de protection 21.

L'enveloppe de protection 21 s'étend autour de la carte électronique 10 et délimite un volume interne 22 du module électronique 100. Un premier capteur de température 30 et un deuxième capteur de température 31 - tous deux de type résistif - sont respectivement collés sur la carte 10 et sur une face intérieure 23 de l'enveloppe de protection 21. Une cellule à effet Peltier 50 comprenant une surface chaude 51 et une surface froide 52 est reliée par collage de sa surface chaude 51 à une surface intérieure 24 de la base 20. Une zone de rétention 53 située à l'aplomb de la cellule à effet Peltier 50 lorsque le module électronique 10 est enfiché dans la baie avionique 60 (figure 2) est recouverte de parylène. La zone de rétention 53 forme une cuvette au centre de laquelle un orifice 54 pourvu d'un clapet 55 traverse l'enveloppe de protection 21 et débouche vers l'extérieur de celle-ci.

Un processeur 40 est relié aux premier et deuxième capteurs de température 30 et 31 ainsi qu'à la cellule à effet Peltier 50. Le processeur 40 est alimenté en énergie via le connecteur d'alimentation 14 et échange des données avec l'extérieur via le connecteur de données 13.

En fonctionnement, le processeur 40 surveille et compare les températures T₃₀ et T₃₁ respectivement mesurées par les premier et deuxième capteurs de température 30 et 31 pour détecter des conditions susceptibles de provoquer une condensation de l'humidité de l'air contenu dans le volume interne 22 sur la carte électronique 10. Une telle situation peut se présenter lorsque l'aéronef 1 est mis en route après avoir été soumis à une température basse. Le fonctionnement de l'un des modules voisins du module 100 peut échauffer l'enveloppe de protection 21 et l'air contenu dans le volume interne 24 avant que la carte électronique 10 n'ait été sollicitée et ait pu monter en température. La carte électronique 10 est donc plus froide que l'air contenu dans le volume interne 24 et de la condensation est susceptible de se former sur la carte électronique 10. La température T₃₀ mesurée par le premier capteur de température 30 est alors inférieure à la température T₃₁ mesurée par le deuxième capteur de température 31 et le processeur 40 détecte des conditions susceptibles de provoquer une condensation de l'humidité de l'air contenu dans le volume interne 22 sur la carte électronique 10. Le processeur 40 déclenche alors le fonctionnement de la cellule à effet Peltier 50. La surface froide 52 de la cellule Peltier 50 crée alors une zone froide dont la température T₅₂ est inférieure à celle de la carte électronique 10. Cette température plus faible de la face froide 52 provoque une condensation sur cette dernière plutôt que sur la carte électronique 10, protégeant la carte électronique 10 de la condensation. Les condensats formés à la surface de la face froide 52 tombent par gravité dans la zone de rétention 53 et sont évacués vers l'orifice 54.

On obtient ainsi un module électronique 100 dont la carte électronique 10 est protégée de la poussière, de l'humidité extérieure, de la fumée et des agressions mécaniques par l'enveloppe de protection 21. L'enveloppe de protection 21 peut être démontable afin d'accéder aisément à la carte électronique 10 qui, ne requérant pas de protection par vernis, est alors facilement réparable. La cellule à effet Peltier 50 permet de protéger la carte électronique 10 de l'humidité contenue dans le volume interne 22.

Selon un deuxième mode de réalisation, le processeur 40 ne déclenche le fonctionnement de la cellule à effet Peltier 50 qu'après avoir préalablement effectuer une comparaison de la température T₃₀ mesurée par le premier capteur de température 30 avec une température seuil Tₑ₁₀, ici égale à vingt degrés centigrades. Si la température T₃₀ mesurée par le premier capteur de température 30 est supérieure à la température seuil Tₛ₁₀, le processeur 40 ne déclenche pas le fonctionnement de la cellule à effet Peltier 50. Dans le cas où la température T₃₀ mesurée par le premier capteur de température 30 est inférieure à la température seuil Tₛ₁₀, le processeur 40 déclenche le fonctionnement de la cellule à effet Peltier 50 lorsque la température T₃₀ mesurée par le premier capteur de température 30 est inférieure à la température T₃₁ mesurée par le deuxième capteur de température 31.

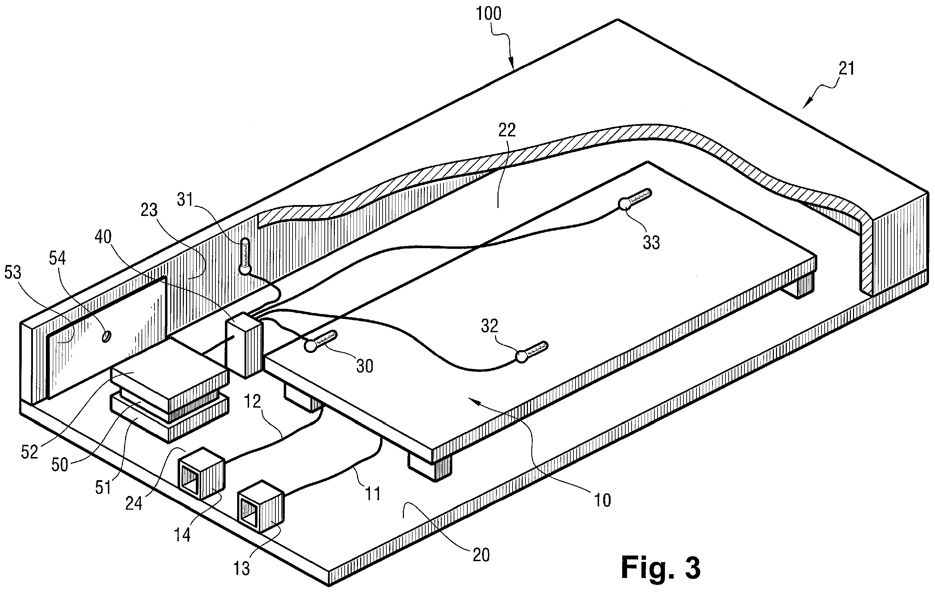

Selon un troisième mode de réalisation représenté en figure 3, la carte électronique 10 comprend un troisième capteur de température 32 et un quatrième capteur de température 33. Le troisième capteur de température 32 et le quatrième capteur de température 33 sont placés sur la carte électronique 10 en des zones déterminées en fonction de la topologie de la carte électronique 10 et de son profil de dissipation thermique pour mesurer les températures des zones de la carte électronique 10 qui peuvent se trouver à des températures plus basses que le reste de la carte électronique. Ces zones peuvent se situer à proximité de composants présentant une inertie thermique importante comme par exemple les masses métalliques de transformateurs de tension. La détection de la condition susceptible de provoquer une condensation de l'humidité de l'air contenu dans le volume interne 22 sur la carte électronique 10 se déroule alors comme suit. Le processeur 40 compare les températures T₃₀, T₃₂ et T₃₃ respectivement mesurées par le premier capteur de température 30, le troisième capteur de température 32 et le quatrième capteur de température 33 et retient la température T_{min(30, 32, 33)} la plus basse. Cette température T_{min(30, 32, 33)} la plus basse peut ensuite être comparée à la température seuil Tᵣ₁₀. Si la température T_{min(30, 32, 33)} la plus basse est inférieure à la température seuil Tₛ₁₀, le processeur 40 compare alors la température T_{min(30, 32, 33)} la plus basse avec la température T₃₂ mesurée par le deuxième capteur de température 32.

Si la température T_{min(30, 32, 33)} la plus basse est inférieure à la température T₃₁ mesurée par le deuxième capteur de température 31, le processeur 40 détecte des conditions susceptibles de provoquer une condensation de l'humidité de l'air contenu dans le volume interne 22 sur la carte électronique 10. Le processeur 40 déclenche alors le fonctionnement de la cellule à effet Peltier 50.

Bien entendu, l'invention n'est pas limitée aux modes de réalisation décrits mais englobe toute variante entrant dans le champ de l'invention telle que définie par les revendications.

En particulier :
- bien qu'ici la zone froide soit générée par une cellule à effet Peltier, l'invention s'applique également à d'autres moyens de générer une zone froide séparée de la carte électronique comme par exemple un traceur électrique qui réchauffe la carte et qui implique donc qu'une zone froide est générée ailleurs que sur la carte (par exemple sur un capotage du connecteur de données ou d'alimentation) ;
- bien qu'ici la zone froide soit générée par une cellule à effet Peltier, l'invention s'applique également à d'autres moyens de générer une zone froide séparée de la carte électronique comme par exemple un cryostat ;
- bien qu'ici les conditions susceptibles de provoquer une condensation de l'humidité de l'air contenu dans le volume interne soient détectées par deux capteurs de température, l'invention s'applique également à d'autres moyens de détecter une condition environnementale prédéterminée comme par exemple un hygromètre, un unique capteur de température éventuellement couplé à un capteur de pression, un détecteur de point de rosée, un capteur de condensation ;

- bien qu'ici les capteurs de température soient des capteurs résistifs, l'invention s'applique également à d'autre moyens de mesure de la température comme par exemple des capteurs infrarouge ou capacitifs ;
- bien qu'ici les capteurs de température soient collés à la carte électronique ou l'enveloppe de protection par collage, l'invention s'applique également à d'autres moyens de solidarisation des capteurs comme par exemples le vissage ou le clippage ;
- bien qu'ici la zone de rétention soit en forme de cuvette et revêtue d'une couche de résine en parylène, l'invention s'applique également à une zone de rétention de forme différente ou plane, protégée ou non par un revêtement pouvant être différent du parylène comme par exemple de la peinture, un insert en matériau synthétique ou métallique ;
- bien qu'ici la zone de rétention soit pourvue d'un orifice débouchant vers l'extérieur du volume interne et pourvue d'un clapet, l'invention s'applique également à d'autres configurations pour la zone de rétention comme par exemple une zone de rétention dont l'orifice est dépourvu de clapet ou bien une zone de rétention dépourvue d'orifice ;
- bien qu'ici la face chaude de la cellule à effet Peltier soit reliée à l'enveloppe de protection, l'invention s'applique également à une liaison de la face chaude de la cellule à effet Peltier à d'autres types d'éléments du module électronique comme par exemple à un châssis thermiquement conducteur du module électronique ;
- bien qu'ici la carte électronique soit fixée sur une base de l'enveloppe de protection, l'invention s'applique également à d'autres configurations de l'enveloppe de protection comme par exemple une enveloppe de protection dont la base serait constituée par la carte électronique elle-même ;
- bien qu'ici les capteurs de température et la cellule à effet Peltier soient reliés à un processeur, l'invention s'applique également à d'autres types d'unités de commande comme par exemple un microcontrôleur ou un FPGA ;
- bien qu'ici la température seuil soit égale à vingt degrés centigrades, m'invention s'applique également à d'autres valeurs de température seuil prédéterminée pouvant être choisie notamment selon les conditions spécifiques de fonctionnement du module électronique, comme par exemple une température seuil supérieure ou inférieure à vingt degrés centigrades ;
- bien qu'ici la carte électronique comprenne un troisième et un quatrième capteur de température, l'invention s'applique également à une carte électronique comprenant un nombre différent de capteurs de température comme par exemple deux capteurs ou plus de trois.

## Revendications

1. Module électronique (100) comprenant une enveloppe de protection (21) délimitant un volume interne (22) et une carte électronique (10) disposée dans le volume interne (22), le module électronique (10) comprenant :
- des moyens de détection (30, 31) d'une condition environnementale prédéterminée du volume interne (22) ;
- des moyens de génération (50) d'une zone froide à l'intérieur du volume interne (22) agencés pour que la zone froide soit séparée de la carte électronique (10) ;
- une unité de commande (40) reliée aux moyens de détection d'une condition environnementale (30, 31) et aux moyens de génération d'une zone froide (50) et **caractérisé en ce que**
l'unité de commande (40) est agencée pour déclencher les moyens de génération (50) d'une zone froide lorsque les moyens de détection d'une condition environnementale prédéterminée du volume interne (22) détectent une condition environnementale susceptible de provoquer une condensation de l'humidité de l'air contenu dans le volume interne (22) sur la carte électronique (10) .

2. Module électronique (100) selon la revendication 1, dans lequel les moyens de détection d'une condition environnementale prédéterminée comprennent un premier capteur de température (30) solidaire de la carte électronique (10).

3. Module électronique (100) selon l'une quelconque des revendications précédentes, dans lequel les moyens de détection d'une condition environnementale prédéterminée comprennent un deuxième capteur de température (31) solidaire de l'enveloppe de protection (21) .

4. Module électronique (100) selon les revendications 2 et 3, dans lequel l'unité de commande (40) est agencée pour déclencher les moyens de génération (50) d'une zone froide lorsqu'une température (T₃₀) mesurée par le premier capteur de température (30) est inférieure à la température (T₃₁) mesurée par le deuxième capteur de température (31).

5. Module électronique (100) selon la revendication 4, dans lequel l'unité de commande (40) est agencée pour ne déclencher les moyens de génération (50) d'une zone froide que si la température (T₃₀) mesurée par le premier capteur de température (30) est inférieure à une température seuil (Tₛ₁₀) prédéterminée.

6. Module électronique (100) selon la revendication 2, dans lequel les moyens de détection d'une condition environnementale prédéterminée comprennent un troisième capteur de température (32) solidaire de la carte électronique (10).

7. Module électronique (100) selon l'une quelconque des revendications précédentes, dans lequel les moyens de génération d'une zone froide comprennent une cellule à effet Peltier (50) qui possède une face chaude (51) et une face froide (52).

8. Module électronique (100) selon la revendication 7, dans lequel la face chaude (51) de la cellule Peltier est thermiquement reliée à l'enveloppe de protection (21) ou à un châssis thermiquement conducteur du module électronique (100).

9. Module électronique (100) selon l'une quelconque des revendications précédentes, dans lequel les moyens de génération d'une zone froide (50) sont agencés pour que des condensats issus de la condensation de l'air contenu dans le volume interne (22) soient dirigés vers une zone de rétention (53) dédiée du volume interne (22) et/ou vers l'extérieur du volume interne (22) .

10. Module électronique (100) selon la revendication 9, dans lequel la zone de rétention (53) est revêtue d'une résine protectrice.

## Patentansprüche

1. Elektronisches Modul (100), umfassend eine Schutzumhüllung (21), die ein Innenvolumen (22) begrenzt, sowie eine Leiterplatte (10), die in dem Innenvolumen (22) angeordnet ist, wobei das elektronische Modul (100) umfasst:
- Detektionsmittel (30, 31) zum Erfassen einer vorbestimmten Umgebungsbedingung des Innenvolumens (22);
- Erzeugungsmittel (50) zum Erzeugen einer kalten Zone im Inneren des Innenvolumens (22), die so ausgebildet sind, dass die kalte Zone von der Leiterplatte (10) getrennt ist;
- eine Steuereinheit (40), die mit den Detektionsmitteln (30, 31) zum Erfassen einer Umgebungsbedingung und mit den Erzeugungsmitteln (50) zum Erzeugen einer kalten Zone verbunden ist, und **dadurch gekennzeichnet, dass** die Steuereinheit (40) ausgebildet ist, um die Erzeugungsmittel (50) zum Erzeugen einer kalten Zone auszulösen, wenn die Detektionsmittel zum Erfassen einer vorbestimmten Umgebungsbedingung des Innenvolumens (22) eine Umgebungsbedingung erfassen, die eine Kondensation der Feuchtigkeit der in dem Innenvolumen (22) enthaltenen Luft auf die Leiterplatte (10) verursachen kann.

2. Elektronisches Modul (100) nach Anspruch 1, bei dem die Detektionsmittel zum Erfassen einer vorbestimmten Umgebungsbedingung einen ersten Temperatursensor (30) umfassen, der fest mit der Leiterplatte (10) verbunden ist.

3. Elektronisches Modul (100) nach einem der vorhergehenden Ansprüche, bei dem die Detektionsmittel zum Erfassen einer vorbestimmten Umgebungsbedingung einen zweiten Temperatursensor (31) umfassen, der fest mit der Schutzumhüllung (21) verbunden ist.

4. Elektronisches Modul (100) nach den Ansprüchen 2 und 3, bei dem die Steuereinheit (40) so ausgebildet ist, dass sie die Erzeugungsmittel (50) zum Erzeugen einer kalten Zone auslöst, wenn eine von dem ersten Temperatursensor (30) gemessene Temperatur (T₃₀) niedriger als die von dem zweiten Temperatursensor (31) gemessene Temperatur (T₃₁) ist.

5. Elektronisches Modul (100) nach Anspruch 4, bei dem die Steuereinheit (40) so ausgebildet ist, dass sie die Erzeugungsmittel (50) zum Erzeugen einer kalten Zone nur auslöst, wenn die von dem ersten Temperatursensor (30) gemessene Temperatur (T₃₀) niedriger als eine vorbestimmte Schwellenwerttemperatur (Tₛ₁₀) ist.

6. Elektronisches Modul (100) nach Anspruch 2, bei dem die Detektionsmittel zum Erfassen einer vorbestimmten Umgebungsbedingung einen dritten Temperatursensor (32) umfassen, der fest mit der Leiterplatte (10) verbunden ist.

7. Elektronisches Modul (100) nach einem der vorhergehenden Ansprüche, bei dem die Erzeugungsmittel zum Erzeugen einer kalten Zone eine Zelle (50) mit Peltier-Effekt umfassen, die eine warme Seite (51) und eine kalte Seite (52) hat.

8. Elektronisches Modul (100) nach Anspruch 7, bei dem die warme Seite (51) der Peltier-Zelle thermisch mit der Schutzumhüllung (21) oder mit einem wärmleitenden Rahmen des elektronischen Moduls (100) verbunden ist.

9. Elektronisches Modul (100) nach einem der vorhergehenden Ansprüche, bei dem die Erzeugungsmittel zum Erzeugen einer kalten Zone (50) so ausgebildet sind, dass die von der Kondensation der in dem Innenvolumen (22) enthaltenen Luft stammenden Kondensate in Richtung einer dedizierten Rückhaltezone (53) des Innenvolumens (22) und/oder nach außerhalb des Innenvolumens (22) geleitet werden.

10. Elektronisches Modul (100) nach Anspruch 9, bei dem die Rückhaltezone (53) von einem Schutzharz überzogen ist.

## Claims

1. An electronic module (100) including a protective casing (21) defining an internal volume (22) and an electronic circuit board (10) placed in the internal volume (22), the electronic module (100) including:
- means (30, 31) for detecting a predetermined environmental condition of the internal volume (22);
- means (50) for generating a cold zone inside the internal volume (22) such that the cold zone is separated from the electronic circuit board (10);
- a control unit (40) that is connected to the means (30, 31) for detecting an environmental condition and to the means (50) for generating a cold zone, and **characterized in that**
the control unit (40) is adapted to trigger the means (50) for generating a cold zone when the means for detecting a predetermined environmental condition in the internal volume (22) detect an environmental condition that is liable to result in the moisture in the air contained in the internal volume (22) condensing on the electronic circuit board (10).

2. The electronic module (100) as claimed in claim 1, in which the means for detecting a predetermined environmental condition comprise a first temperature sensor (30) fastened to the electronic circuit board (10).

3. The electronic module (100) as claimed in either one of the preceding claims, in which the means for detecting a predetermined environmental condition comprise a second temperature sensor (31) fastened to the protective casing (21).

4. The electronic module (100) as claimed in claims 2 and 3, in which the control unit (40) is adapted to trigger the means (50) for generating a cold zone when a temperature (T₃₀) measured by the first temperature sensor (30) is lower than the temperature (T₃₁) measured by the second temperature sensor (31) .

5. The electronic module (100) as claimed in claim 4, in which the control unit (40) is adapted to trigger the means (50) for generating a cold zone only if the temperature (T₃₀) measured by the first temperature sensor (30) is lower than a predetermined threshold temperature (Tₛ₁₀).

6. The electronic module (100) as claimed in claim 2, in which the means for detecting a predetermined environmental condition comprise a third temperature sensor (32) fastened to the electronic circuit board (10).

7. The electronic module (100) as claimed in any one of the preceding claims, in which the means for generating a cold zone comprise a Peltier effect cell (50) that has a hot face (51) and a cold face (52).

8. The electronic module (100) as claimed in claim 7, in which the hot face (51) of the Peltier effect cell is thermally connected to the protective casing (21) or to a thermally conductive chassis of the electronic module (100).

9. The electronic module (100) as claimed in any one of the preceding claims, in which the means (50) for generating a cold zone are such that the condensates resulting from the condensation of the air contained in the internal volume (22) are directed to a dedicated retention zone (53) of the internal volume (22) and/or to the exterior of the internal volume (22).

10. The electronic module (100) as claimed in claim 9, in which the retention zone (53) is coated with a protective resin.
